Europäisches Patentamt

European Patent Office

Office européen des brevets

(11) Publication number: **0 677 951 A2**

# EUROPEAN PATENT APPLICATION

(21) Application number: **95300553.5**

(22) Date of filing: **30.01.95**

(51) Int. Cl.⁶: **H04N 5/16, H04N 5/44**

(30) Priority: **12.04.94 KR 7603494**

(43) Date of publication of application:
**18.10.95 Bulletin 95/42**

(84) Designated Contracting States:
**DE FR GB IT**

(71) Applicant: **GOLDSTAR CO. Ltd.**
**20, Yoido-dong,**
**Youngdungpo-ku**
**Seoul (KR)**

(72) Inventor: **Kim, Dae Jin, Keon Young Villa**
**918-202,**
**265 Yatap-Dong,**
**Bundang-ku,**
**Seongnam-si,**
**Kyungki-do (KR)**

(74) Representative: **Cross, Rupert Edward Blount**
**et al**
**BOULT, WADE & TENNANT**
**27 Furnival Street**
**London EC4A 1PO (GB)**

(54) **A device for compensating for DC errors in a high definition television receiver.**

(57) A device for compensating for direct current (DC) errors in a television receiver. The device includes a non-interference detecting circuit for detecting a DC value representing a channel signal in response to a control signal indicating whether an interference or non-interference condition exists, an interference detecting circuit for detecting a DC value representing the channel signal in response to a synchronization signal, a circuit for selecting a detected DC value either from the non-interference circuit or the interference detecting circuit based on whether the control signal indicates the interference or non-interference condition, and a circuit for providing a DC compensation value based on a selected DC value from the selecting circuit.

FIG.2

## FIELD OF THE INVENTION

This invention relates to a device for compensating for direct current (DC) errors which are generated during signal processing in the mixer, baseband amplifier and analog to digital converter (ADC) in a high definition television (HDTV) receiver.

## BACKGROUND OF THE INVENTION

In general, signals received by an antenna, while passing through mixers, baseband amplifiers and ADCs in the HDTV, are modulated into baseband signals and converted into digital signals. During these modulation and conversion processes, DC signals are generated. These DC signals need be compensated to restore the received signal to the original form through filtering, and therefore, the device for compensating for DC errors is indispensable in the HDTV.

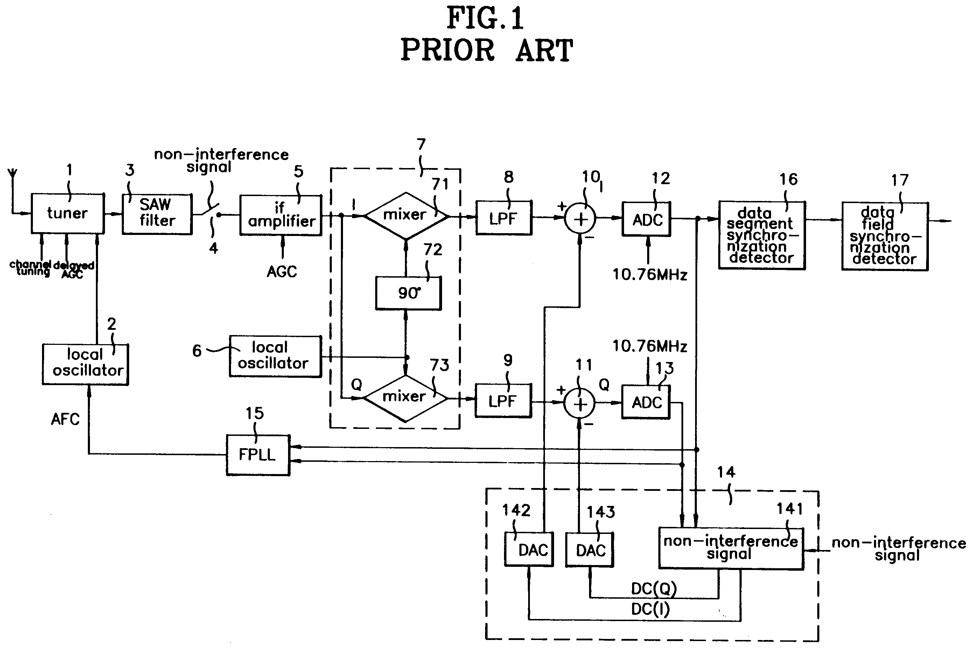

FIG.1 shows a block diagram of a conventional HDTV receiver having such a DC correction device. More specifically, such a conventional HDTV receiver includes a tuner 1 for selecting a desired channel in response to a channel tuning signal and a delayed AGC (Auto Gain Control) signal applied externally to the tuner 1. The turner 1 provides "primary" demodulation of the selected channel signal into a 920MHz band signal. A local oscillator, which produces a signal having a 876MHz frequency, provides "secondary" demodulation of the signal, which has been already primarily demodulated in the tuner 1, into a signal of a secondary intermediate frequency (IF) of a 44MHz bandwidth. A SAW filter 3 provides filtering of the signal, which has already been converted into the secondary IF signal of a 44MHz bandwidth, into a vestigial sideband (VSB) wave pattern.

Further, a non-interference DC switch 4 provides switching ("on" or "off") of the signal received from the SAW filter 3 in response to a non-interference DC signal externally applied to the switch 4. An IF amplifier 5 amplifies the IF signal from the non-interference switch 4 under the control of an automatic gain control (AGC signal). A synchronization detector 7 divides the signal from the IF amplifier 5 into an I channel signal and a Q channel signal, and provides "tertiary" demodulation for each of the divided signals into a baseband signal. A local oscillator 6 provides a frequency signal to the synchronization detector 7 for demodulation. A low-pass filter (LPF) 8 and a LPF 9 filter the I channel signal and the Q channel signal, respectively, from the synchronisation detector 7 to a 6MHz bandwidth.

Yet further, a DC correction device 14 provides a DC correction value in response to the non-interference DC signal externally applied thereto. A subtracter 10 and a subtracter 11 subtract the DC correction value from the DC compensation device 14 from a value representing the signal received from the LPF 8 and a value representing from the signal from the LPF 9, respectively. An ADC 12 and an ADC 13 analog-to-digital (A/D) convert the signals from the subtracter 10 and the subtracter 11, respectively, into digital signals having a sampling frequency of 10.76MHz and apply the converted digital signals to the DC correction device 14.

A data segment synchronization detector 16 detects a data segment synchronization data from the signal received from the ADC 12. A data field synchronisation detector 17 detects a data field synchronisation data from the signal received from the data segment synchronization detector 16. A frequency phase locked loop (FPLL) 15 detects the phase difference between the signals received from the ADC 12 and the ADC 13, and causes the local oscillator 2 to provide a locking frequency and phase in accordance with the detected phase difference.

Further, referring to Fig. 1, the synchronization detector 7 includes a phase invertor 72 which shifts the phase of the signal received from the local oscillator 6 by 90 degree; a mixer 71 which mixes the signal received from the phase invertor 72 with the signal received from the IF amplifier 5 and applies the mixed signal to the LPF 8; and a mixer 73 which mixes the signal received from the local oscillator 6 with the signal received from the IF amplifier 5 and applies the mixed signal to the LPF 9.

Yet further, the DC correction device 14 includes a non-interference DC detector 141 for detecting non-interference DC values from the signals received from the ADCs 12 and 13 in response to the non-interference DC signal externally applied thereto; and digital to analog converters (DACs) 142 and 143 which digital-to-analog (D/A) convert the signals received from the non-interference DC detector 141 and apply the converted signals to the subtracters 10 and 11, respectively.

The operation of the conventional HDTV receiver described above is explained hereinafter. The signal received from the antenna, which represents a selected channel in response to the channel tuning signal and the delayed AGC inputs by the tuner 1, is primarily demodulated into a 920MHz bandwidth by a primary local oscillator (not shown) in the tuner 1, and secondarily demodulated into a secondary intermediate frequency of a 44MHz bandwidth by the secondary local oscillator 2. The signal converted into such a 44MHz secondary intermediate frequency bandwidth through the tuner 1 is "VSB filtered" through the SAW filter 3, that is filtered into a signal having a VSB wave pattern. The VSB wave pattern signal is then applied to the IF amplifier 5 through the non-interference DC switch 4. In this instant, the non-interference DC switch is deactivated (turned off) only when DC error correction is activated and it is activated (turned on) at other times.

The signal received through the non-interference DC switch 4 is amplified at the IF amplifier 5 under the control of the automatic gain control (AGC) signal, and divided into the I channel signal and the Q channel signal and then tertiarily demodulated into baseband signals at the synchronization detector 7 according to the signal received from the tertiary local oscillator 6.

That is, of the signals received from the IF amplifier 5, the I channel signal is tertiarily demodulated after its phase is shifted by 90 degree at the mixer 71 in response to the signals received both from the phase invertor 72 and the tertiary local oscillator 6. The Q channel signal is tertiarily demodulated at the mixer 73 according to the signal received from the local oscillator 6.

The I channel signal received from the mixer 71 of the synchronization detector 7 is filtered to a 6MHz bandwidth by the LPF 8. The filtered signal is compensated for DC errors (i.e., via subtraction) in reference to a DC correction value received from the DC correction device 14 by the subtracter 10, and then A/D converted into a digital signal with a 10.76MHz sampling frequency by the ADC 12. Likewise, the Q channel signal received from the mixer 73 of the synchronization detector 7 is filtered to a 6MHz bandwidth. The filtered signal is compensated for DC errors (i.e., via subtraction) in reference to a DC correction value received from the DC correction device 14 by the subtracter 11, and then A/D converted into a digital signal with a 10.76MHz sampling frequency by the ADC 13.

From the digital signals received from the ADCs 12 and 13, the FPLL 15 detects a pilot signal, and also detects the difference in frequency and phase between the digital signals to provide a locking frequency and phase for the secondary local oscillator 2.

Such digital signals from the ADCs 12 and 13 are also applied to the DC correction device 14 for DC correction. The non-interference detector 141 provides a DC value corresponding to each of the digital signals received from the ADCs 12 and 13 in response to the non-interference DC signal externally applied thereto.

The operation of the DC correction device 14 is explained hereinafter. To detect a DC value, the pulse of the non-interference DC signal having a "high" signal level is applied to the non-interference DC switch 4 to turn off the non-interference DC switch 4 and also to activate the non-interference DC detector 141 in the DC correction device 14. When the non-interference DC detector 141 is activated, a DC value representing the I axis DC(I) and a DC value representing the Q axis DC(Q) are detected from the I and Q channel digital signals, respectively, which digital signals are received from the ADCs 12 and 13. Then, the DACs 142 and 143 convert DC(I) and DC(Q), respectively, from the non-interference DC detector 141 into analog signals representing DC correction values. Each analog signal representing the DC correction value is applied to a respective one of the subtracters 10 and 11.

Since the VSB signal uses the I channel signal only, the signal only from the ADC 12 is applied to the synchronization detector 16, and the segment synchronization data corresponding to the horizontal synchronization signal of the NTSC is extracted therefrom. Further, the segment synchronization data corresponding to the vertical synchronization signal of the NTSC is extracted at the data field synchronization detector 17.

However, since the conventional DC correction device can compensate for DC errors only at the non-interference DC detector 141, and the non-interference DC detector 141 becomes operative only under the non-interference condition in which the IF terminal switch 4 is turned off, cutting signal input to the IF amplifier 5, the conventional DC correction device can only compensate for DC errors each time only when the TV is turned on or a new channel selection is made. Further, the DC offset value necessary to compensate for DC errors may vary with temperature and power supply voltage, and therefor, the DC offset value needs be corrected as time varies. However, since the DC correction device is incapable of compensating for DC errors as the DC offset value may vary from time to time, the conventional DC correction device tends to cause misinterpretion of the data in the I channel or the phase data for phase locking in the Q channel.

## SUMMARY OF THE INVENTION

The objects and advantages of particular embodiments of the present invention will be set forth in the description which follows.

To accomplish the above objects, the device for compensating for direct current (DC) errors in a television receiver comprises, in a first embodiment, a first detecting means for detecting a DC value representing a channel signal in response to a control signal indicating a signal condition; a second detecting means for detecting a DC value representing a channel signal in response to a synchronization signal; means for selecting a detected DC value from either the first detecting means or the second detecting means based on whether the control signal indicates a non-interference signal condition or not; and means, coupled to the selecting means, for providing a DC compensation signal based on a selected DC value.

Further, according to another embodiment of the present invention, the device for compensating for direct current (DC) errors in a television receiver includes a non-interference detecting means for detecting a DC value representing a channel signal in response to a control signal indicating whether an interference or non-interference condition exists; an interference detecting means for detecting a DC value representing the channel signal in response to a synchronization signal; means for selecting a detected DC value either from the non-interference means or the interference detecting means based on whether the control signal indicates the interference or non-interference condition; and means for providing a DC compensation value based on a selected DC value from the selecting means.

The accompanying drawings, which are incorporated in and constitute a part of this specification, illustrate one embodiment of the invention and together with the description, serve to explain the principles involved.

BRIEF DESCRIPTION OF THE DRAWINGS

Fig. 1 is a block diagram representing a conventional HDTV receiver having a DC correction device.

Fig. 2 is a block diagram representing a DC correction device according to an embodiment of the present invention.

Fig. 3 is a more detailed block diagram of the DC correction device of Fig. 2.

Fig. 4 is a timing chart representing a field synchronization data.

Fig. 5 is a diagram of a non-interference DC detector in the DC correction device of Fig. 2.

DESCRIPTION OF THE PREFERRED EMBODIMENT

Reference will now be made in detail to the embodiment of the invention which is illustrated in the accompanying drawings. Wherever possible, the same reference numbers will be used throughout the drawings to refer to the same or like parts.

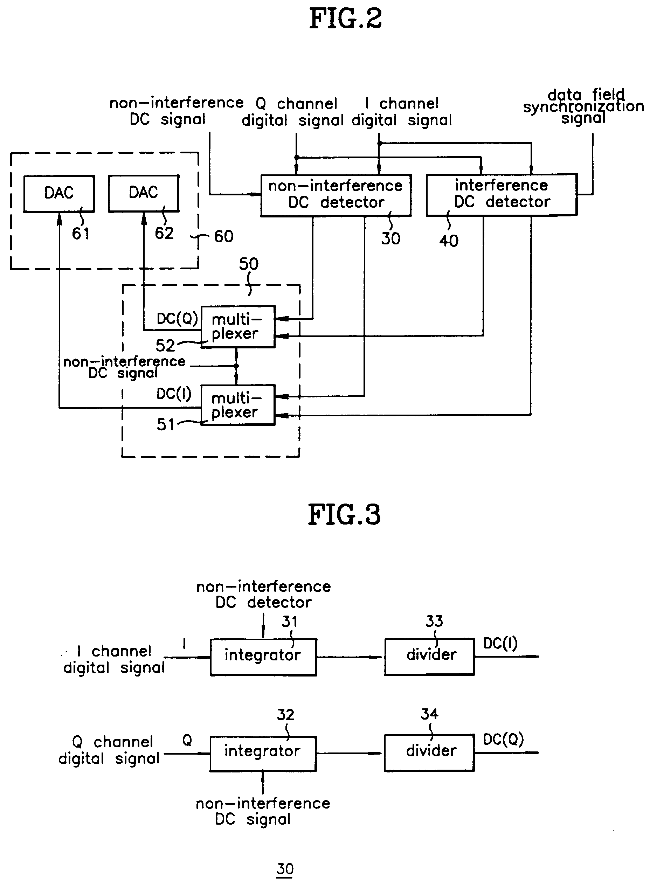

The structure and operation of the illustrated DC correction device is explained hereinafter in references to Figs. 2, 3, 4, and 5. Referring to Fig. 2, the DC correction device, as embodied herein, preferably includes a non-interference DC detector 30, an interference DC detector 40, a selection part 50, and a digital to analog (D/A) conversion part 60. The non-interference DC detector 30 detects direct current (DC) values from digital signals of an I channel and a Q channel applied thereto under a non-interference condition. In the non-interference condition, an input to the IF amplifier 5 (shown in Fig. 1) is cut off. The non-interference DC detector 40 detects DC values from the digital signals provided from the I channel and the Q channel applied thereto for each field in response to a data field synchronization signal externally applied thereto. Similarly, the interference DC detector 40 detects DC values from the digital signals of the I channel and the Q channel applied thereto for each frame in response to a data frame synchronization signal externally applied thereto.

The selection part 50 includes a multiplexer 51 which selects a DC value representing the I axis DC(I) between the DC(I)s received from the non-interference DC detector 30 and the interference DC detector 40, and a multiplexer 52 which selects a DC value representing the Q axis DC(Q) between the DC(Q)s received from the non-interference DC detector 30 and the interference DC detector 40, thereby the selection part 50 selects the DC value received from either the non-interference DC detector 30 or the interference DC detector 40. The control signal which controls such selection by the multiplexers 51 and 52 is the non-interference DC signals representing the non-interference condition.

The digital-to-analog (D/A) conversion part 60 includes a digital-to-analog converter (DAC) 61 for D/A conversion of the DC value representing the I axis DC(I) received from the selection part 50 and a DAC 62 for D/A conversion of the DC value representing the Q axis DC(Q) received from the selection part 50, thereby the D/A conversion part 60 carries out D/A conversion of the DC value received from the selection part 50.

Referring to Fig. 3, the non-interference DC detector 30, as embodied herein, preferably includes integrators 31 and 32 for integrating the digital signal, which signals are provided from a respective one of the I and Q channels in accordance with the non-interference DC signal representing the non-interference condition in reference to the number of symbols (N); and further includes dividers 33 and 34 for dividing the signal received from a respective one of the integrators 31 and 32 by the number of symbols (N), thereby the detector 30 detects a DC value by calculating an average value representing the digital signal provided from each of the I and Q channels.

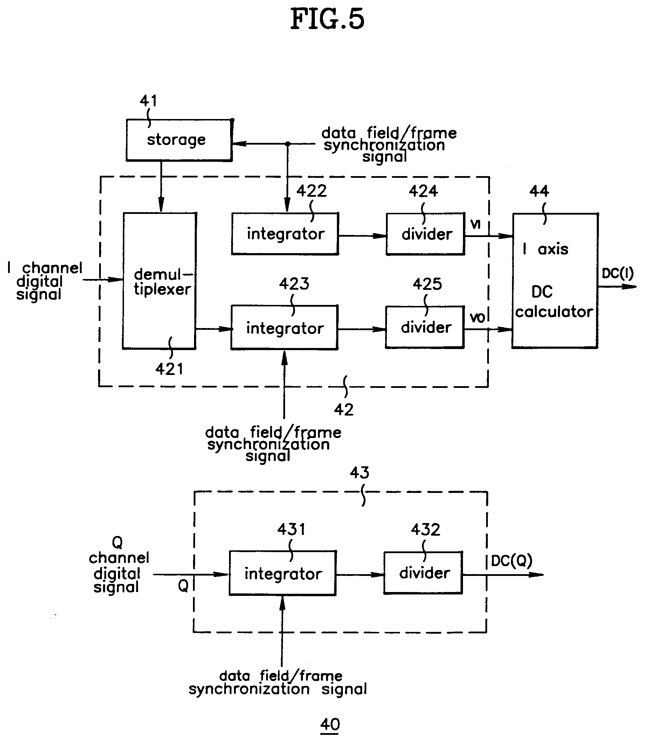

Referring to Fig. 5, the interference DC detector 40, as embodied herein, includes a storage part 41 for storing the field (or frame) synchronization data; a reception terminal level calculation part 42 for calculating a reception terminal level of the digital signal which are provided from the I channel in response to the data field synchronization signal externally applied thereto in accordance with the field synchronization data provided from the storage part 41; an I axis DC calculator 44 for calculating the DC representing the I axis in accordance with values representing the signals received form the reception terminal level calculation part 42; and a Q axis DC calculation part 43 for calculating the DC value representing the Q axis from the digital signals which are provided from the Q channel in response to the data field synchronization signals externally applied thereto. The storage part 41, as embodied herein, preferably includes a ROM (read only memory).

The reception terminal level calculation part 42, as embodied herein, preferably includes a demultiplexer 421 for dividing the digital signal provided from the I channel in accordance with the field synchronization data stored in the storage part 41 into a signal representing a value '1' and a signal representing a value '0'; integrators 422 and 423 for integrating each of the '1' and '0' level signals received from the demultiplexer 421 as many times as half the number of symbols (N/2) in response to the data field synchronization signal externally applied thereto; and dividers 44 and 45 for dividing the signals received from the integrator 422 and 423, respectively, by half the number of symbols (N/2).

The Q axis DC calculation part 43, as embodied herein, preferably includes an integrator 431 for integrating the digital signal which is provided from the Q channel in response to the data field synchronization signal externally applied thereto as many times as the number of symbols (N), and a divider 432 for dividing the signal received from the integrator 431 by the number of symbols (N).

The operation of the DC correction device, as embodied herein, is explained hereinafter. First, when the pulse of the non-interference DC signal is at a "high" level after the signal received through the antenna is modulated into a baseband signal and then converted into a digital signal after passing through the mixer, baseband amplifier, and ADC, the non-interference DC detector is operated. That is, DC values are detected from the digital signals provided from the I and Q channels under the non-interference condition in which the IF signal input is cut off. Then, the DC value representing the I axis DC(I) and the DC value representing the Q axis DC(Q) are produced and applied to the multiplexers 51 and 52.

The process for producing the DC value representing the I axis DC(I) and the DC value representing the Q axis DC(Q) under the non-interference condition are explained hereinafter, in reference to Figs. 2 and 3. When the pulse of the non-interference DC signal is high, the integrator 31 integrates the digital signal provided from the I channel as many times as the number of symbols (N), which number corresponds to the pulses of the non-interference DC signal, to increase the signal-to-noise ratio (SNR). The divider 33 divides this integrated digital signal by the number of symbols (N) and applies the divided signal to the multiplexer 51 as the DC value representing the I axis DC(I).

Likewise, when the pulse of the non-interference DC signal is high, the integrator 32 integrates the digital signal provided from the Q channel as many times as the number of symbols (N), which number corresponds to the pulses of the non-interference DC signal, to increase the SNR. The divider 33 divides this integrated digital signal by the number of symbols (N) and applies the divided signal to the multiplexer 52 as the DC value representing the Q axis DC(Q).

The DC(I) and DC(Q) received from the dividers 33 and 34, respectively, of the non-interference DC detector 30 are selected by the multiplexers 51 and 52, respectively, of the selection part 50, and applied to the D/A conversion part 60. At this time, the control signal, which is the non-interference DC signal, is externally applied to the multiplexers 51 and 52. Under the non-interference condition in which the IF signal input is cut off, the pulse input of the non-interference DC signal is high. Under this circumstance, the control signal controls the multiplexers 51 and 52 to select the DC(I) and DC(Q) received from the dividers 33 and 34, respectively, of the non-interference DC detector 30.

The DAC 61 converts the DC(I) received from the multiplexer 51 into an analog signal and applies the converted signal to the I channel subtracter (shown in Fig. 1) for compensation for DC errors. Likewise, the DAC 62 converts the DC(Q) from the multiplexer 52 into an analog signal and applies the converted signal to the Q channel subtracter (shown in Fig. 1) for compensation for DC errors.

Referring to Fig. 1, the ADC 12 converts the I channel signal, which has been compensated for DC errors under the non-interference condition, into a digital signal. The data segment synchronization detector 16 and the data field synchronization detector extract from the converted digital signal a data field synchronization signal and a data frame synchronization signal, respectively. The extracted data field synchronization signal (or data frame synchronization signal) is applied to the interference DC detector 40 (shown in Fig. 2), to operate the interference DC detector 40 to detect the DC value once for each field (or once for each frame).

As described above, the interference DC detector 40, as embodied herein, is controlled to be operable in response to the data field synchronization signal for detection of the DC value for each field, or alternatively in response to the data frame synchronization signal for detection of the DC value for each frame. When the data field synchronization signal or the data frame synchronization signal is applied, the interference DC detector 40 is operated to detect the DC value from the digital signals provided from the I and Q channels even at times when the IF signal input is not cut off, and the DC value representing the I axis DC(I) and the DC value representing the Q axis DC(Q) are provided and applied to the multiplexers 51 and 52.

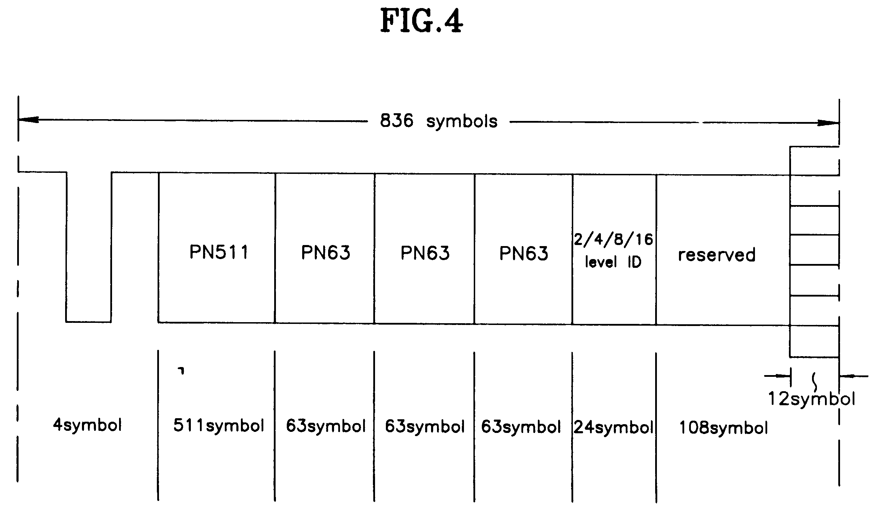

The process for producing the DC value representing the I axis DC(I) and the DC value representing the Q axis DC(Q) under the non-interference condition is explained hereinafter in reference to Figs. 4 and 5. The storage part 41 stores a 512 field synchronization data having the same number of '0's and '1's. Referring to Fig. 4, the field synchronization data has a segment synchronization pattern of '1001' in the first segment of four symbols, a pseudo random sequence of PN 511, PN 63, and PN 63 in the second segment, a basic level of 2/4/8/16 level ID for 2, 4, 8, and 16 levels in the third segment, and a reserved area in the last segment. Herein, the field synchronization data consists of two levels except the last symbol level.

The field synchronization data intended to be used at the interference DC detector 40 is an even numbered data having the same number of '1's and '0's in a known PN sequence. To produce an even numbered data out of the 511 data of the PN 511, either the first or the last digit of the 511 data has to be excluded to make an even number data, or one digit has to be added at the beginning or end of the 511 data to make it 512.

When it is intended to make a 512 data, i.e., a number having a exponential power of 2, for the convenience of calculation, by adding one digit at the beginning or end of the PN 511, a 512 data having the same number of '1's and '0's can be made. If the number of '1's and '0's of the 512 data happens not to be the same in such a 512 data, when consecutive 512 digits are selected from the total 700 data of PN 511, PN 63, PN 63, and PN 63, the 512 data is selected such that the number of '1's and '0's becomes the same. If this is difficult, the data having the number of 256, 128, or 64 digits only can be selected.

The operation of the interference DC detector 40 using a field synchronization data pattern is explained hereinafter in reference to Fig. 5. Of those two signal levels at which the field synchronization data is transmitted, the '1' signal level is set at a +5 magnitude; the '0' signal level at a -5 magnitude; and a 1.25 magnitude is added to the pilot when the field synchronisation data is transmitted. Accordingly, where V1 is defined as the reception terminal level of the digital signal of the I channel received from the ADC 12 (shown in Fig. 1) when '1' is transmitted from the transmission terminal; and V0 as the reception terminal level of the digital signal of the I channel received from the ADC 13 (shown in Fig. 1) when '0' is transmitted from the transmission terminal,

$$V1 = ( 5 + 1.25 ) \cdot A + DC \qquad (1)$$
$$V0 = ( -5 + 1.25 ) \cdot A + DC \qquad (2)$$

where A is an amplification factor,
then the DC value will be,

$$DC = ( 5/2 ) V0 - ( 3/2 ) V1 \qquad (3)$$

Accordingly, since the field synchronization data transmitted from the transmission terminal is already known, while having the known field synchronization data stored in the storage part 41, the DC value can be calculated according to the equation (3) through dividing the field synchronization data received at the reception terminal into the two levels based on the known field synchronization data irrespective of the magnitude of the field synchronization data received at the reception terminal. That is, referring to Fig. 5, in response to the data field synchronization signal, the storage part 41 transmits a 512 field synchronization data stored therein to the demultiplexer 421, and the demultiplexer 421 demultiplexes the digital signal provided from the I channel in, accordance with the transmitted field synchronization data and applies the demultiplexed signal to the integrators 422 and 423.

In other words, the transmitted field synchronization data controls the demultiplexer 421 to apply the digital signal input from the I channel to the integrator 422 if the transmitted data is identified as '1', and controls the demultiplexer 421 to apply the digital signal to the integrator 423 if the transmitted data is '0'.

The digital signal from the I channel from the demultiplexer 421, when the transmitted field synchronization data is '1', is integrated by the integrator 422 as many times as half the total number of symbols (N/2), and the integrated signal is divided by the divider 424 by half the total number of symbols (N/2). The divided signal becomes the signal of the reception terminal level V1 when the transmission terminal has transmitted the '1' level data, and is then applied to the I axis DC calculator 44.

Likewise the digital signal from the I channel from the demultiplexer 421, when the transmitted field synchronization data is '0', is integrated by the integrator 423 as many times as half the total number of symbols (N/2), and the integrated signal is then divided by the divider 425 by half the total number of symbols (N/2). The divided signal becomes the signal of the reception level V0 when the transmission terminal has transmitted the '0' level data, and is then applied to the I axis DC calculator 44.

The reception terminal levels V1 and V0 of the signals received from the dividers 424 and 425 are calculated at the I axis DC calculator 44 according to the equation (3), and the DC value representing the I axis DC(I) is transmitted as in the equation (3). The I axis DC calculator 44 calculates the DC value representing the I axis DC(I) and provides the calculated value to the multiplexer 51 (shown in Fig. 2).

If the number of occurrences of '1's and '0's is the same, since there is no pilot in the Q channel due to the properties of VSB, the average value of the data will be '0'. Accordingly, if the digital signal from the Q channel is integrated as many times as the number of symbols (N) and then divided by the same number of symbols (N), the average DC value representing the Q axis DC(Q) can be obtained.

That is, when the data field synchronization signal is applied, the integrator 431 is operated to integrate the digital signal from the Q channel as many times as the number of symbols N, which are then divided by the divider 432 by the same number of symbols N and subsequently transmitted to the multiplexer 52 (shown in Fig. 2) as the DC value representing the Q axis DC(Q). In this instant, to reduce error, it is preferred to take a 512 data as practically possible.

Under this circumstance, since the pulse of the non-interference DC signal will have a low signal level due to interferences, the control signal controls the multiplexers 51 and 52 of the selection part 51 to select the DC value representing the I axis DC(I) and the DC value representing the Q axis DC (Q), respectively, that are provided from the interference DC detector 40. The DC(I) selected by and received from the multiplexer 51 is converted into an analog signal by the DAC 61, and applied to the I channel subtracter (shown in Fig. 1) to be used for compensation for DC errors. Likewise, the DC(Q) selected by and received from the multiplexer 52 is converted into an analog signal by the DAC 62, and applied to the Q channel subtracter (shown in Fig. 1) to be used for compensation for DC errors.

In other words, when the TV is switched on for the first time or the TV channel is changed, the DC(I) and DC(Q) from the non-interference DC detector 30 are detected by the multiplexers 51 and 52, respectively. However, when the data field synchronization signal is fixed, e.g., after the TV is turned on and fixed to a channel, the DC(I) and DC(Q) are detected by the interference DC detector 40 once for each field or once for each frame, and selected at the multiplexers 51 and 52, respectively.

Therefore, the described DC correction device has an advantage of compensating for DC errors continuously as necessary using the field synchronization data even at times when the IF input signal is not cut off.

It will be apparent to those skilled in the art that various modifications and variations can be made in the camera and method of the present invention without departing from the spirit or scope of the invention. Thus, it is intended that the present invention cover the modifications and variations of this invention provided they come within the scope of the appended claims and their equivalents.

**Claims**

1. A device for compensating for direct current (DC) errors in a television receiver, comprising:
   a non-interference detecting means for detecting a DC value representing a channel signal in response to a control signal indicating whether an interference or non-interference condition exists;
   an interference detecting means for detecting a DC value representing the channel signal in response to a synchronization signal;
   means for selecting a detected DC value either from the non-interference means or the interference detecting means based on whether said control signal indicates the interference or non-interference condition; and
   means for providing a DC compensation value based on a selected DC value from said selecting means.

2. The device for compensating for direct current (DC) errors in a television receiver as claimed in claim 1, wherein each of said interference and non-interference means includes a first means for detecting a DC value representing an I channel signal received from an I channel of the television receiver and a second means for detecting a DC value representing a Q channel signal received from a Q channel of the television receiver.

3. The device for compensating for direct current (DC) errors in a television receiver as claimed in claim 1, wherein said selecting means includes a multiplexer for selecting said detected DC value.

4. The device for compensating for direct current (DC) errors in a television receiver as claimed in claim 1, wherein said selecting means includes means for selecting the detected value from the non-interference detecting means when said control signal indicates the non-interference condition, and selects the detected value from the interference detecting means other times.

5. The device for compensating for direct current (DC) errors in a television receiver as claimed in claim 1, wherein said control signal has a high level when the non-interference condition exists and a low level when the interference condition exits.

6. The device for compensating for direct current (DC) errors in a television receiver as claimed in claim 1, wherein said non-interference detecting means:

at least one integrator for integrating the channel signal as many times as the number of symbols; and

at least one divider for dividing an integrated signal from said integrator by the number of symbols.

7. The device for compensating for direct current (DC) errors in a television receiver as claimed in claim 1, wherein said interference detecting means includes:

a storage means for storing a synchronization data representing said synchronization signal;

a reception terminal level calculation means for determining a reception terminal level of the channel signal representing an I channel of the television receiver based on said synchronization data in response to the synchronization signal; and

an I axis DC calculation means for determining a DC value representing a channel signal representing a Q channel of the television receiver in response to the synchronisation signal.

8. The device for compensating for direct current (DC) errors in a television receiver as claimed in claim 1, wherein said selecting means includes at least two multiplexers, each multiplexer coupled to both said interference and non-interference detecting means and providing a DC value corresponding to a respective one of an I channel and a Q channel of the television receiver.

9. The device for compensating for direct current (DC) errors in a television receiver as claimed in claim 7, wherein said reception terminal level calculation means includes:

a demultiplexer for dividing the channel signal representing the I channel according to the synchronization data stored in the storage means into '1' and '0' level signals,

first and second integrators coupled to said demultiplexer and each integrator for integrating a respective one of the '1' and '0' level signals as many times as half the number of symbols (N/2) in response to the synchronization signal; and

first and second dividers coupled to a respective one of the first and second integrators, and each divider for dividing an integrated signal by half the number of symbols (N/2).

10. The device for compensating for direct current (DC) errors in a television receiver as claimed in claim 7, wherein the storage means includes a ROM (read only memory).

11. The device for compensating for direct current (DC) errors in a television receiver as claimed in claim 7, wherein the storage means includes means for storing a 512 field synchronization data.

12. The device for compensating for direct current (DC) errors in a television receiver as claimed in claim 7, wherein said Q axis DC calculation means includes:

an integrator for integrating the channel signal representing the Q channel in response to the synchronisation signal as many times as the number of symbols (N); and

a divider for dividing an integrated signal from said integrator by the number of symbols (N).

13. The device for compensating for direct current (DC) errors in a television receiver as claimed in claim 8, wherein each of said multiplexers is coupled to said control signal and wherein said selecting means includes means for selecting one of said multiplexers based on whether the control signal indicates the interference or non-interference condition.

14. The device for compensating for direct current (DC) errors in a television receiver as claimed in claim 11, wherein the 512 field synchronisation data has the same number of '0' and '1' values.

15. A device for compensating for direct current (DC) errors in a television receiver, comprising:

a first detecting means for detecting a DC value representing a channel signal in response to a control signal indicating a signal condition;

a second detecting means for detecting a DC value representing a channel signal in response to a synchronization signal;

means for selecting a detected DC value from either the first detecting means or the second detecting means based on whether said control signal indicates a non-interference signal condition or not; and

means, coupled to said selecting means, for providing a DC compensation signal based on a selected DC value.

FIG.1
PRIOR ART

# FIG.2

# FIG.3

30

# FIG.4

836 symbols

| 4symbol | PN511 511symbol | PN63 63symbol | PN63 63symbol | PN63 63symbol | 2/4/8/16 level ID 24symbol | reserved 108symbol | 12symbol |

EP 0 677 951 A2

# FIG.5

40